# EUROPÄISCHE PATENTSCHRIFT

(11) **EP 0 429 000 B1**
(45) Veröffentlichungstag und Bekanntmachung des Hinweises auf die Patenterteilung: **13.03.1996**
(21) Anmeldenummer: 90121851.1
(22) Anmeldetag: 15.11.1990
(51) Int. Cl.: H04H 1/00

(54) **RDS-Rundfunkempfänger mit einer Einrichtung zur länderspezifischen Auswertung von RDS-Daten**
RDS broadcast receiver with a device for country-specific interpretation of RDS data
Récepteur radio avec RDS pourvu d'un dispositif d'interprétation des données de RDS selon les spécifications nationales

(30) Priorität: 20.11.1989 DE 3938457
(43) Veröffentlichungstag der Anmeldung: 29.05.1991
(73) Patentinhaber: GRUNDIG E.M.V. Elektro-Mechanische Versuchsanstalt Max Grundig GmbH & Co. KG, D-90762 Fürth (DE)
(72) Erfinder: Liebig, Peter, Grundig E.M.V., W-8510 Fuerth (DE)

(56) Entgegenhaltungen:
- EP-A- 0 263 253
- EP-A- 0 337 609
- FUNKSCHAU, Band 58, Nr. 1, Januar 1986, Seiten 43-47, München, DE; "Radio- Daten-System: Neue Entwicklung auf Hörfunkwellen"
- ELEKTRONIK, Band 37, Nr. 7, 31. März 1988, Seiten 77-78,80-82, München, DE; F. STOLLENWERK: "Datenübertragung im UKW-Rundfunk"

## Beschreibung

Mit dem Radio-Daten-System (RDS) wird für den Rundfunkhörer unhörbar parallel zum ausgestrahlten Rundfunkprogramm ein binärer Datenstrom übertragen, der dem Empfangsgerät eine Reihe von Abstimm-, Schalt- und Betriebsinformationen liefert. Unter anderem werden zum Beispiel als Abstimmhilfe fortlaufend sogenannte PI-Codes (Programme Identification Codes), AF-Codes (Alternative Frequency Codes) oder künftig auch PTY-Codes (Programme Type Codes) gesendet, die dem Empfänger die Zuordnung einer Senderfrequenz zu einer bestimmten Programmkette oder Programmart erlauben und ihm alternative Frequenzen anbieten, mit denen das gleiche Programm empfangen werden kann. Dies ist besonders für den mobilen Rundfunkempfang mit ständig sich ändernden Empfangsbedingungen nützlich.

Als Schaltsignale sind unter anderem DI-Codes (Decoder Identification Codes) vorgesehen, die das Empfangsgerät automatisch einer bestimmten Betriebsart (z.B. Kunstkopfstereophonie, komprimierte Übertragung etc.) anpassen und deren Funktion auch über ein Display angezeigt werden kann.

Die Auswertung bzw. Anzeige dieser exemplarisch aufgezählten RDS-Informationen erfordert zur Optimierung der Gerätefunktionen eine länderspezifische Anpassung sowohl an die geographisch als auch sprachlich bedingten Erfordernisse des jeweiligen Landes. So wird man für den Wechsel auf alternative Frequenzen in einem vorwiegend gebirgigen Land eine andere Strategie verfolgen als in einem reinen Flachland.

Aus der europäischen Offenlegungsschrift EP-A 0 263 253 ist ein Verfahren zur Übertragung von Textnachrichten im RDS-Signal bekannt. Bei diesem Verfahren ist es vorgesehen, Textnachrichten, die länger sind als im RDS-System erlaubt, in mehrere Textblöcke aufzuteilen. Es ist dort weiterhin ein Sprachgenerator für einen RDS-Empfänger vorgesehen, der die übermittelten Textnachrichten durch Auswertung des länderspezifischen Teiles des PI-Codes in der richtigen Sprache wiedergibt.

Aus der europäischen Offenlegungsschrift EP-A 0 337 609 ist ein RDS-Empfänger bekannt, der einen Permanentspeicher enthält, in dem ein oder mehrere länderspezifische PI-Codes abgespeichert sind. Bei der Erstinbetriebnahme oder bei einer Reset-Funktion des RDS-Empfängers wird der länderspezifische PI-Code vom Permanentspeicher in einen Schreib-/Lesespeicher übertragen, der vom Benutzer mit individuellen Daten überschrieben werden kann. In dem Fall, daß mehrere länderspezifische PI-Codes im Permanentspeicher abgelegt sind, wird von einer Steuereinheit der länderspezifische Teil des PI-Codes eines empfangenen Senders ausgewertet und der entsprechende länderspezifische PI-Code in den Schreib-/Lesespeicher übertragen.

Das Wechselverhalten wird außerdem bestimmt durch die Art der landesweiten Verteilung programmgleicher Sendestationen.

Sollen Betriebs- oder Bedienhinweise über ein Display angezeigt oder mit Hilfe eines Sprachgenerators angesagt werden, so wird man vorzugsweise die jeweilige Landessprache verwenden.

Aufgrund dieser länderbedingten Abweichungen war es bisher für einen Gerätehersteller mit hohem Exportanteil unumgänglich, je nach Bestimmungsland unterschiedliche Geräteausführungen zu produzieren. Dies ist im Hinblick auf wirtschaftliche Fertigung und vertriebliche Disposition verbesserungsbedürftig.

Ferner ist es für den mobilen Rundfunkempfang von großem Vorteil, wenn im grenzüberschreitenden Verkehr das Empfangsgerät die jeweils optimale Strategie für das Einstellen des am besten zu empfangenden Senders selbständig auswählt.

Aufgabe der vorliegenden Erfindung ist es deshalb, einen RDS-Rundfunkempfänger, insbesondere ein RDS-Autoradio anzubieten, bei dem die Auswertung bzw. Anzeige der im RDS-Datensignal enthaltenen Informationen in Abhängigkeit der mit dem PI-Code empfangenen Länderkennung automatisch den Erfordernissen des jeweiligen Landes angepaßt wird.

Ferner ist es Ziel der Erfindung, Radiotext-Informationen bei einer akustischen Übertragung mit Hilfe eines Sprachgenerators aufgrund der Länderkennung automatisch in der richtigen Landessprache wiederzugeben.

Die Erfindung wird nachfolgend anhand der Zeichnungen erläutert. Es zeigt
- Fig. 1: das Strukturschema des PI-Codes
- Fig. 2: das Verteilungsschema der Länderkennungen
- Fig. 3: das Blockschaltbild für ein Ausführungsbeispiel des erfindungsgemäßen RDS-Rundfunkempfängers.

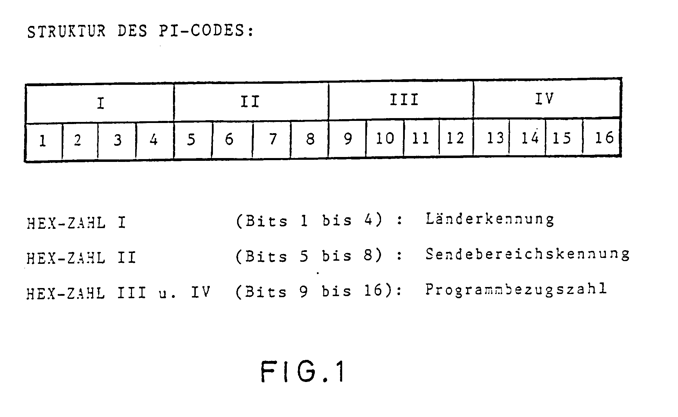

Wie aus der Spezifikation des Radio-Daten-Systems, pr. EN 50 067 vom Oktober 1988, hervorgeht, besteht der PI-Code aus einer vierstelligen hexadezimalen Zeichenfolge, wobei jede HEX-Zahl mit 4 Bit binär codiert ist, so daß der PI-Code insgesamt eine Folge von 16 Bits umfaßt (s. Fig. 1).

Die erste HEX-Zahl (Bits 1 bis 4) enthält die Länderkennung, d.h. sie gibt an, welcher staatlichen Hoheit der Sender zuzuordnen ist.

Die zweite HEX-Zahl (Bits 5 bis 8) definiert den Sendebereich, d.h., sie unterscheidet zwischen lokalen, regionalen, supra-regionalen, nationalen und internationalen Programmen.

Die dritte und vierte HEX-Zahl (Bits 9 bis 16) kennzeichnen die verschiedenen Programmgruppen, die länderspezifisch aufgeteilt sind.

So lautet z. B. der PI-Code für die Programmkette "Bayern 3" in hexadezimaler Schreibweise "D 323". In binärer Schreibweise ergibt sich daraus die Bit-Folge "1101 0011 0010 0011".

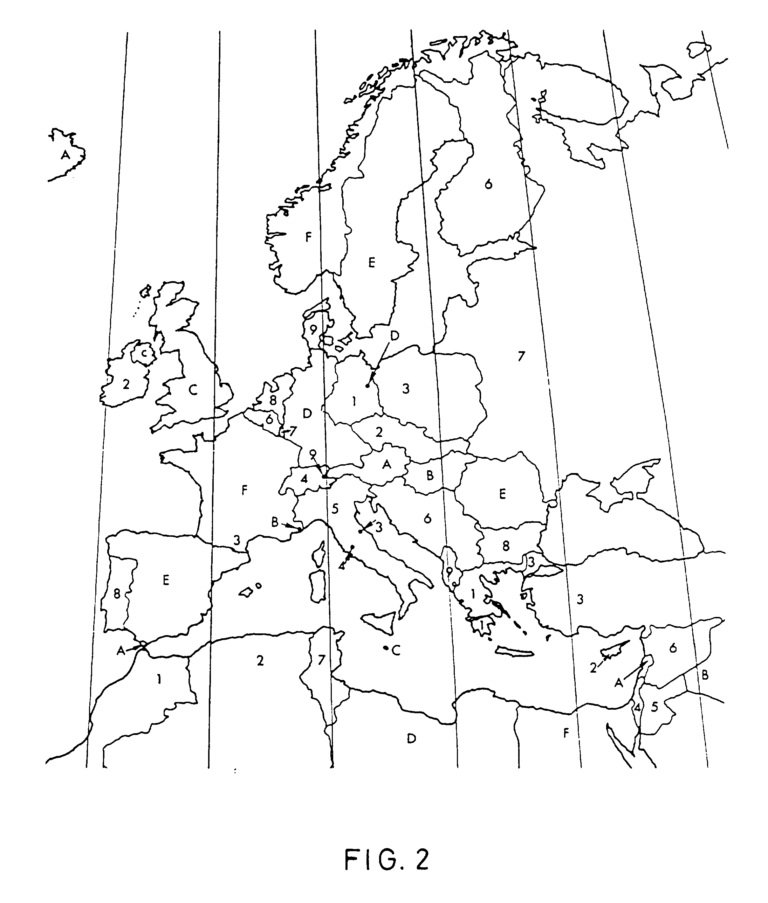

Fig. 2 zeigt die Verteilung der Länderkennzeichen im europäischen Rundfunkgebiet. Da innerhalb der hexadezimalen Zahlenreihe nur 16 Varianten möglich sind, wurden weit voneinander entfernte Länder mit dem gleichen Ländercode gekennzeichnet. Für die vorliegende Erfindung ist jedoch bedeutsam, daß jeweils für ein größeres Gebiet (z. B. Bundesrepublik Deutschland mit sämtlichen Anliegerstaaten) eindeutige Länderkennzeichnungen gegeben sind, so daß mit einer einzigen Geräteausführung eine große Anzahl von Ländern versorgt werden kann.

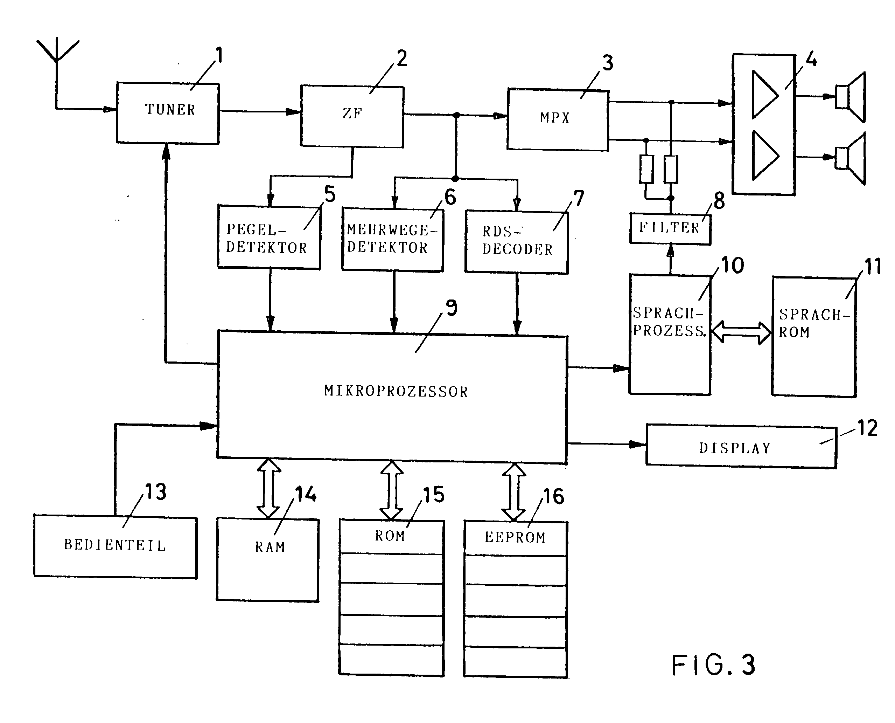

Der in Fig. 3 dargestellte RDS-Rundfunkempfänger enthält in an sich bekannter Weise einen Synthesizer-Tuner 1, einen ZF-Verstärker 2 zum selektiven Verstärken und Demodulieren der Zwischenfrequenz, einen Stereo-Decoder 3 zum Decodieren des Stereo-Multiplexsignals und einen Stereoverstärker 4. Als zentrale Steuereinheit, verbunden mit dem Bedienteil 13, dient der Mikroprozessor 9, der auch zur Sendereinstellung das notwendige Abstimmsignal an den Synthesizer-Tuner 1 liefert. Die Empfangsqualität wird mit dem Pegeldetektor 5 und dem Mehrwegedetektor 6 überwacht. Der Pegeldetektor 5 entnimmt dem ZF-Verstärker 2 nach Maßgabe des ZF-Signalpegels eine Meßgröße zur Feststellung der Signalfeldstärke und wandelt diese in ein digitales Steuersignal für den Mikroprozessor 9. Der Mehrwegedetektor 6 wird mit dem demodulierten MPX-Signal gespeist und liefert bei Mehrwegeempfang ebenfalls ein digitales Steuersignal an den Mikroprozessor 9. Die Analog-/Digital-Wandlung der Steuersignale kann auch im Mikroprozessor erfolgen, sofern der Prozessor mit entsprechenden Wandlereingängen versehen ist.

Der RDS-Decoder 7 wird ebenfalls mit dem demodulierten Multiplexsignal beaufschlagt. Nach einer 57 kHz-Bandpaßfilterung wird das in Quadratur amplitudenmodulierte RDS-Signal demoduliert und die nach einer anschließenden Biphase- und Differential-Decodierung gewonnenen digitalen Daten zur Weiterverarbeitung dem Mikroprozessor 9 zugeführt.

Als Arbeitsspeicher besitzt der Mikroprozessor 9 den RAM-Speicher 14. Das Betriebsprogramm mit seinen länderspezifischen Varianten ist in den einzelnen Speicherebenen des ROM-Speichers 15 abgelegt. Der EEPROM-Speicher 16 dient als nichtflüchtiger Programmspeicher und beinhaltet in seinen einzelnen Speicherebenen für jedes abgespeicherte Programm neben dem PI-Code und dem PS-Code ("Programme Service Name"-Code zur Anzeige des Namens einer Programmkette) eine Anzahl ausgewählter alternativer Frequenzen für einen spontanen Programmabruf.

Die in der jeweiligen Speicherebene des Programmspeichers 16 enthaltenen Daten werden bei Abruf eines bestimmten Programms durch den Mikroprozessor 9 in den Arbeitsspeicher 14 kopiert. Anschließend werden die AFs durch kurzzeitiges Abstimmen des Empfängers in Bezug auf Feldstärke, Mehrwegeempfang, Sendermitte, RDS-Übertragungsqualität und PI-Code überprüft und entsprechend ihrer Empfangsqualität in der Reihenfolge sortiert. Zum Schluß wird der Tuner 1 durch den Mikroprozessor 9 auf die Frequenz mit der höchsten Feldstärke abgestimmt.

Sobald der Mikroprozessor 9 bei der Prüfung des PI-Codes eine bestimmte Länderkennung erfaßt, erfolgt die Adressierung des ROM-Speichers 15 zugunsten der länderspezifischen Variante des Betriebsprogrammes. Dies hat zur Folge, daß das Wechselverhalten des Empfängers auf alternative Frequenzen bei Verschlechterung der Empfangsverhältnisse oder die automatische Suche nach einer neuen empfangswürdigen Programmkette optimal auf die Sender landschaft des jeweiligen Landes abgestimmt wird.

Im RDS-Datenpaket sind auch Informationen über die Programmart PTY (Programme Type Code) und Schaltbefehle zur Decodersteuerung DI (Decoder Identification Code) vorgesehen. Mit dem PTY-Code können 31 verschiedene Programmarten, wie z. B. "Nachrichten", "Politik", "Sport", "U-Musik", "E-Musik" usw., im Display 12 angezeigt werden. Der DI-Code dient zum Kennzeichnen 16 verschiedener Betriebsarten, wie z. B. "monophone Übertragung", "stereophone Übertragung", "Kunstkopfstereophonie" usw. Es können damit einzelne Decoder ein- und ausgeschaltet werden, bzw. kann die Betriebsart im Display 12 optisch dargestellt werden. Da die alphanumerische Darstellung im Display 12 in der jeweiligen Landessprache erfolgen muß, wird die mit dem PI-Code empfangene Länderkennung dazu benutzt, den entsprechenden Speicherbereich im ROM-Speicher 15 für die länderspezifische Wortausgabe zu adressieren.

Das Radio-Daten-System erlaubt weiterhin die codierte Übertragung eines Radiotextes RT, d.h., es können z. B. programmbegleitende Informationen mit bis zu 64 alphanumerischen Textzeichen im Display 12 angezeigt werden. Da im Autoradio aus Sicherheitsgründen eine optische Darstellung unerwünscht ist, werden, wie bereits in der Spezifikation des Radio-Daten-Systems, pr. EN 50 067, Ausgabe Nov. 1988, vorgeschlagen, die codierten Radiotext-Signale zur Ansteuerung eines Sprachgenerators für eine akustische Textausgabe verwendet. Dieser Sprachgenerator besteht beispielsweise aus dem Sprachprozessor 10, dem ROM-Speicher 11 und dem Filter 8. Die im Mikroprozessor 9 aufbereiteten Radiotext-Daten werden zur Ansteuerung des Sprachprozessors 10 verwendet, der sich die Daten der entsprechenden phonetischen Sprachelemente aus dem ROM-Speicher 11 holt. Das vom Sprachprozessor 10 erzeugte Sprachsignal wird nach einer internen Digital-/Analog-Wandlung über das Tiefpaßfilter 8 dem Stereoverstärker 4 zugeführt und über die Gerätelautsprecher wiedergegeben. Der Sprachgenerator ist für die Erzeugung verschiedener Landessprachen eingerichtet und wird durch Auswerten der im PI-Code empfangenen Länderkennung vom Mikroprozessor 9 entsprechend programmiert.

## Patentansprüche

1. RDS-Rundfunkempfänger, insbesondere RDS-Autoradio mit elektronischen Abstimm- und Speicherelementen, mit einer Einrichtung zur Beurteilung der Empfangsqualität und mit einer zentralen Steuereinheit,
**dadurch gekennzeichnet, daß**
a) ein nichtflüchtiger Speicher (15) vorgesehen ist, der das Betriebsprogramm und dessen länderspezifische Varianten enthält,
b) ein RDS-Decoder (7) und eine zentrale Steuereinheit (9) vorgesehen sind, wobei der RDS-Decoder (7) so ausgeführt ist, daß er der zentralen Steuereinheit (9) Steuersignale entsprechend der im RDS-Datensignal enthaltenen länderspezifischen Informationen liefert, und
c) die zentrale Steuereinheit (9) so ausgeführt ist, daß sie zur Berücksichtigung länderspezifischer Besonderheiten entsprechend der im PI-Code des RDS-Signales enthaltenen Länderkennung den nichtflüchtigen Speicher zum Abruf der länderspezifischen Variante des Betriebsprogrammes adressiert.

2. RDS-Rundfunkempfänger nach Anspruch 1,
**dadurch gekennzeichnet**, daß die zentrale Steuereinheit (9) als Mikroprozessor ausgebildet ist, der nach Aufrufen der im nichtflüchtigen Speicher (15) abgelegten länderspezifischen Variante des Betriebsprogramms den Wechsel auf alternative Frequenzen im Arbeitsspeicher (14) bei Verschlechterung der Empfangsverhältnisse entsprechend der für das jeweilige Land festgelegten Wechselstrategie vollzieht.

3. RDS-Rundfunkempfänger nach Ansprüchen 1 und/oder 2,
**dadurch gekennzeichnet**, daß der nichtflüchtige Speicher (15) Wortdaten für diverse Betriebsinformationen zur Ausgabe in verschiedenen Landessprachen enthält, die vom Mikroprozessor (9) entsprechend der über den RDS-Decoder (7) empfangenen Länderkennung und zusätzlicher Betriebsdaten abgerufen und dem Display (12) zur Anzeige zugeführt werden.

4. RDS-Rundfunkempfänger nach einem der vorstehenden Ansprüche 1 bis 3, **dadurch gekennzeichnet** , daß zur akustischen Darstellung von Radiotext-Informationen oder sonstiger Betriebshinweise ein Sprachgenerator (10, 11) vorgesehen ist, dessen Sprachspeicher (11) Daten phonetischer Elemente für verschiedene Landessprachen enthält und vom Mikroprozessor (9) über den Sprachprozessor (10) entsprechend der über den RDS-Decoder (7) empfangenen Länderkennung und der darzustellenden Informationen adressiert wird.

## Claims

1. RDS radio receiver, in particular RDS car radio having electronic tuning and memory elements, having a device for assessing the reception quality and having a central control unit, characterized in that
a) a nonvolatile memory (15) is provided which contains the operating programme and its country-specific variants,
b) an RDS decoder (7) and a central control unit (9) are provided, the RDS decoder (7) being so designed that it supplies the central control unit (9) with control signals corresponding to the items of country-specific information contained in the RDS data signal, and
c) the central control unit (9) is so designed that, to take account of the country-specific features in accordance with the national identification contained in the PI code of the RDS signal, it addresses the nonvolatile memory in order to call up the country-specific variant of the operating programme.

2. RDS radio receiver according to Claim 1, characterized in that the central control unit (9) is designed as a microprocessor which, after calling up the country-specific variant of the operating programme stored in the nonvolatile memory (15), performs the change to alternative frequencies in the working memory (14) if the reception conditions deteriorate in accordance with the change strategy laid down for the respective country.

3. RDS radio receiver according to Claims 1 and/or 2, characterized in that the nonvolatile memory (15) contains word data for diverse items of operating information for output in various national languages which are called up by the microprocessor (9) in accordance with the national identification received via the RDS decoder (7) and additional operating data and are fed to the display (12) for the purpose of indication.

4. RDS radio receiver according to one of the preceding Claims 1 to 3, characterized in that, for the purpose of acoustically presenting items of radio text information or other operating instructions, a speech generator (10, 11) is provided whose speech memory (11) contains phonetic element data for various national languages and is addressed by the microprocessor (9) via the speech processor (10) in accordance with the national identification received via the RDS decoder (7) and the information to be presented.

## Revendications

1. Récepteur radio RDS, c'est-à-dire du système à transmission radio et à transmission de données, notamment autoradio RDS comportant des éléments électroniques de réglage d'accord et de mémoire, un dispositif pour évaluer la qualité de réception et une unité centrale de commande,
caractérisé en ce que
a) il est prévu une mémoire non volatile (.15), qui contient le programme de service et ses variantes spécifiques aux pays,
b) il est prévu un décodeur RDS (7) et une unité centrale de commande (9), le décodeur RDS (7) étant réalisé de telle sorte qu'il délivre des signaux de commande à l'unité centrale de commande (9) en fonction des informations spécifiques aux pays, contenues dans le signal de données RDS, et
c) l'unité centrale de commande (9) est réalisée de telle sorte que pour tenir compte de particularités spécifiques aux pays, elle commande la mémoire non volatile, en fonction de l'indicatif du pays, contenu dans le code PI, c'est-à-dire le code d'identification de programme, du signal RDS, pour appeler la variante, spécifique au pays, du programme de service.

2. Récepteur radio RDS selon la revendication 1, caractérisé en ce que l'unité centrale de commande (9) est agencée sous la forme d'un microprocesseur, qui après appel de la variante du programme de service, qui est spécifique au pays et est mémorisée dans la mémoire non volatile (15), exécute la commutation sur des fréquences alternatives dans la mémoire de travail (14) lors d'une altération des conditions de réception, en fonction de la stratégie de commutation fixée pour le pays considéré.

3. Récepteur radio RDS selon les revendications 1 et/ou 2, caractérisé en ce que la mémoire non volatile (15) contient des données de mots pour diverses informations de fonctionnement pour leur délivrance en différentes langues des pays, qui sont appelées par le microprocesseur (9) en fonction de l'indicatif du pays, reçu par l'intermédiaire du décodeur RDS (7), et de données de service supplémentaires et sont envoyées, pour leur affichage, au dispositif d'affichage (12).

4. Récepteur radio RDS selon l'une des revendications précédentes 1 à 3, caractérisé en ce que pour la représentation acoustique d'informations de texte radiodiffusées ou d'autres indications de service, il est prévu un générateur de signaux vocaux (10,11), dont la mémoire de signaux vocaux (11) contient des données d'éléments phonétiques pour différentes langues des pays et est adressé par le microprocesseur (9) par l'intermédiaire du processeur vocal (10) en fonction de l'indicatif, reçu par l'intermédiaire du décodeur RDS (7), et des informations devant être représentées.
